# EUROPEAN PATENT SPECIFICATION

(11) **EP 0 565 452 B1**
(45) Date of publication and mention of the grant of the patent: **10.09.1997**
(21) Application number: 93400928.3
(22) Date of filing: 08.04.1993
(51) Int. Cl.: H01L 39/22, H01L 29/40

(54) **Superconducting device having a superconducting channel formed of oxide superconductor material**
Supraleitendes Bauelement mit einem Kanal aus supraleitendem Oxyd
Dispositif à supraconducteur ayant un canal en oxyde supraconducteur

(30) Priority: 09.04.1992 JP 116946/92
(43) Date of publication of application: 13.10.1993
(73) Proprietor: Sumitomo Electric Industries, Ltd., Osaka 541 (JP)
(72) Inventor: Tanaka, So, F-75116 Paris (FR); Iiyama, Michitomo, F-75116 Paris (FR)
(74) Representative: Ballot, Paul Denis Jacques

(56) References cited:
- EP-A- 0 475 838
- EP-A- 0 477 103
- EP-A- 0 484 252
- EP-A- 0 545 801
- IBM TECHNICAL DISCLOSURE BULLETIN. vol. 32, no. 3A, August 1989, NEW YORK US pages 77 - 78

## Description

### Background of the Invention

### Field of the invention

The present invention relates to a superconducting device, and more specifically to a superconducting device having an extremely thin superconducting channel formed of oxide superconductor material.

### Description of related art

Devices which utilize superconducting phenomena operate rapidly with low power consumption so that they have higher performance than conventional semiconductor devices. Particularly, by using an oxide superconductor material which has been recently advanced in study, it is possible to produce a superconducting device which operates at relatively high temperature.

A Josephson device is one of well-known superconducting devices. However, since the Josephson device is a two-terminal device, a logic gate which utilizes Josephson devices becomes complicated configuration. Therefore, three-terminal superconducting devices are more practical.

Typical three-terminal superconducting devices include two types of super-FET (field effect transistor). The first type of the super-FET includes a semiconductor channel, and a superconductor source electrode and a superconductor drain electrode which are formed closely to each other on both side of the semiconductor channel. A portion of the semiconductor layer between the superconductor source electrode and the superconductor drain electrode has a greatly recessed or undercut rear surface so as to have a reduced thickness. In addition, a gate electrode is formed through a gate insulating layer on the portion of the recessed or undercut rear surface of the semiconductor layer between the superconductor source electrode and the superconductor drain electrode.

A superconducting current flows through the semiconductor layer (channel) between the superconductor source electrode and the superconductor drain electrode due to the superconducting proximity effect, and is controlled by an applied gate voltage. This type of the super-FET operates at a higher speed with a low power consumption.

The second type of the super-FET includes a channel of a superconductor formed between a source electrode and a drain electrode, so that a current flowing through the superconducting channel is controlled by a voltage applied to a gate formed above the superconducting channel.

Both of the super-FETs mentioned above are voltage controlled devices which are capable of isolating output signal from input one and of having a well defined gain.

However, since the first type of the super-FET utilizes the superconducting proximity effect, the superconductor source electrode and the superconductor drain electrode have to be positioned within a distance of a few times the coherence length of the superconductor materials of the superconductor source electrode and the superconductor drain electrode. In particular, since an oxide superconductor has a short coherence length, a distance between the superconductor source electrode and the superconductor drain electrode has to be made less than about a few ten nanometers, if the superconductor source electrode and the superconductor drain electrode are formed of the oxide superconductor material. However, it is very difficult to conduct a fine processing such as a fine pattern etching, so as to satisfy the very short separation distance mentioned above.

On the other hand, the super-FET having the superconducting channel has a large current capability, and the fine processing which is required to product the first type of the super-FET is not needed to product this type of super-FET.

It is estimated that superconducting carriers (Cooper pairs) are forced in the direction away from the gate electrode, so that the space charge of a depletion layer in which there is no superconducting particle satisfy the neutrality condition with the charge between the gate electrode and the gate insulator, when a signal voltage is applied to the gate electrode of the super-FET having a superconducting channel. Since the carrier density of an oxide superconductor ranges 10²⁰ - 10²¹ /cm³, which is a medium value between that of a semiconductor and a metal, the depletion layer has a thickness of a few nanometers in case of a superconducting channel of an oxide superconductor and applied voltage of a few volts.

Therefore, in order to obtain a complete ON/OFF operation, the superconducting channel of an oxide superconductor should have an extremely thin thickness of a few nanometers. In addition, it is necessary to process the gate with high precision of sub-micrometers, which has a suitable length relative to its thickness.

The European Patent Application EP-A-0 477 103 describes a superconducting device comprising a thin superconducting channel formed of an oxide superconductor deposited on a principal surface of a substrate, a gate insulator formed directly on the oxide superconductor, a gate electrode formed on the gate insulator, and a superconducting source region and a superconducting drain region formed of the oxide superconductor on an exposed surface of the superconducting channel at opposite sides of the gate electrode.

However, in the super-FET, special attention is not given to the source-drain distance, namely the sum of the distance between the superconducting source region and the gate electrode and the distance between the gate electrode and the superconducting drain region. Since it has been considered that the critical current density of the superconducting channel is locally changed at a gate portion just under the gate electrode so that the gate portion becomes resistive, when a voltage is applied to the gate electrode. Other portions of the superconducting channel is considered to be superconducting regardless of the voltage which is applied to the gate electrode. Therefore, it is considered that they have no effect on the modulation of the current flowing through the superconducting channel, even if they are very long relative to the gate portion.

However, an oxide superconductor is a superconductor of the second kind so that flux penetrates into it under some conditions, while the oxide superconductor is in the superconducting state. A portion of the oxide superconductor at the center of the penetrating flux is in a normal conducting state and it is resistive. In addition, if large superconducting current flows through the superconducting channel of an oxide superconductor, since the flux migrates in the superconducting channel, a voltage is generated between the both ends of the superconducting channel.

In a super-FET of a prior art, as mentioned above, no attention is given to the distance between the superconducting source region and the gate electrode and the distance between the gate electrode and the superconducting drain region. Therefore, when the superconducting channel is resistive, a voltage applied to the gate electrode can change resistance of only the gate portion just under the gate electrode.

If the superconducting channel is very long relative to the gate portion, the change of the resistance of the gate portion becomes very small relative to the whole resistance of the superconducting channel. Therefore, in this case, even if large modulation is performed at the gate portion, little current modulation and little voltage modulation are observed between the both ends of the superconducting channel.

By this, the conventional super-FET does not have an enough performance.

### Summary of the Invention

Accordingly, it is an object of the present invention to provide an FET type superconducting device having a superconducting region constituted of an extremely thin oxide superconductor film, which have overcome the above mentioned defects of the conventional ones.

The above and other objects of the present invention are achieved in accordance with the present invention by a superconducting device comprising a thin superconducting channel, a superconducting source region and a superconducting drain region of an oxide superconductor, the superconducting source region and the superconducting drain region being formed at respective ends of the superconducting channel which connects the superconducting source region and the superconducting drain region, so that superconducting current can flow through the superconducting channel between the superconducting source region and the superconducting drain region, and a gate electrode applying an electric field to the superconducting channel through a gate insulator for controlling the superconducting current flowing through the superconducting channel, characterized in that the superconducting channel connects the top portions of the superconducting source region and the superconducting drain region and has a length which is the shortest distance between the superconducting source region and the superconducting drain region, the gate insulator is disposed on the bottom side of the superconducting channel, and the gate electrode is disposed on the bottom side of the gate insulator, and in that the gate electrode is equal to or longer than one third of the length of the superconducting channel but shorter than the superconducting channel.

In case that the gate electrode is shorter than the superconducting channel, only the resistance of the gate portion (the portion just under the gate electrode) of the superconducting channel is changed when a voltage is applied to the gate electrode. However, gate electrode of the super-FET in accordance with the present invention has a length not shorter than one third of that of the superconducting channel. Therefore, the change of resistance of the gate portion is very large compared to the whole resistance of the superconducting channel. Thus, large modulation of both current and voltage of the superconducting channel and complete ON/OFF operation of the superconducting channel are realized as the above-mentioned super-FET.

In the super-FET in accordance with the present invention, the superconducting channel, the superconducting source region and the superconducting drain region can be arranged arbitrarily, so long as the superconducting source region and the superconducting drain region is arranged separately from each other and the superconducting channel connects them.

In one preferred embodiment, the superconducting channel connects the top portions of the superconducting source region and the superconducting drain region and the superconducting channel, the superconducting source region and the superconducting drain region have a planar upper surface.

It is also preferable that the superconducting channel connects the middle portions of the superconducting source region and the superconducting drain region and the gate electrode and the gate insulator are bent along the upper surface of the superconducting channel, the superconducting source region and the superconducting drain region. In this type of the super-FET, superconducting current flows into or flows from the superconducting channel efficiently so that the current capability of the super-FET can be improved.

In another preferred embodiment, the superconducting channel connects the bottom portions of the superconducting source region and the superconducting drain region and the gate electrode and the gate insulator are arranged on the superconducting channel between the superconducting source region and the superconducting drain region. The super-FET preferably includes an insulating layer which surrounds side surfaces of the gate electrode and which isolates the gate electrode from the superconducting source region and the superconducting drain region. In this case, the super-FET has a substantially planar upper surface. This planar upper surface is favorable for forming conductor wirings in a later process.

In the super-FET in accordance with the present invention, the superconducting channel preferably connects the top portions of the superconducting source region and the superconducting drain region and the gate electrode is arranged under the superconducting channel through the gate insulating layer between the superconducting source region and the superconducting drain region. The super-FET also has a planar upper surface which is favorable for forming conductor wirings in a later process.

According to another aspect of the present invention, there is provided a superconducting device comprising a thin superconducting channel, a superconducting source region and a superconducting drain region of an oxide superconductor, the superconducting source region and the superconducting drain region being formed at respective ends of the superconducting channel which connects the superconducting source region and the superconducting drain region, so that superconducting current can flow through the superconducting channel between the superconducting source region and the superconducting drain region, and a gate electrode applying an electric field to the superconducting channel through a gate insulator for controlling the superconducting current flowing through the superconducting channel, characterized in that the superconducting source region and the superconducting drain region are placed in stagged fashion and the superconducting source region, the superconducting channel and the superconducting drain region are arranged to form a crank in the named order, and in that the superconducting channel has a length I_{SD} which is the shortest distance between the superconducting source region and the superconducting drain region, and the length of the gate electrode ranges from one third of the length of the superconducting channel to one and a half times the superconducting channel length.

In a preferred embodiment, the oxide superconductor is formed of high-T_{c} (high critical temperature) oxide superconductor, particularly, formed of a high-T_{c} copper-oxide type compound oxide superconductor for example a Y-Ba-Cu-O compound oxide superconductor material, a Bi-Sr-Ca-Cu-O compound oxide superconductor material, and a Tl-Ba-Ca-Cu-O compound oxide superconductor material.

In addition, the substrate can be formed of an insulating substrate, preferably an oxide single crystalline substrate such as MgO, SrTiO₃, CdNdAlO₄, etc. These substrate materials are very effective in forming or growing a crystalline film having a high degree of crystalline orientation. However, the superconducting device can be formed on a semiconductor substrate if an appropriate buffer layer is deposited thereon. For example, the buffer layer on the semiconductor substrate can be formed of a double-layer coating formed of a MgAl₂O₄ layer and a BaTiO₃ layer if silicon is used as a substrate.

Preferably, the superconducting channel is formed of a *c*-axis oriented oxide superconductor thin film and the superconducting source region and the superconducting drain region are formed of *a*-axis oriented oxide superconductor thin films.

The above and other objects, features and advantages of the present invention will be apparent from the following description of preferred embodiments of the invention with reference to the accompanying drawings.

### Brief Description of the Drawings

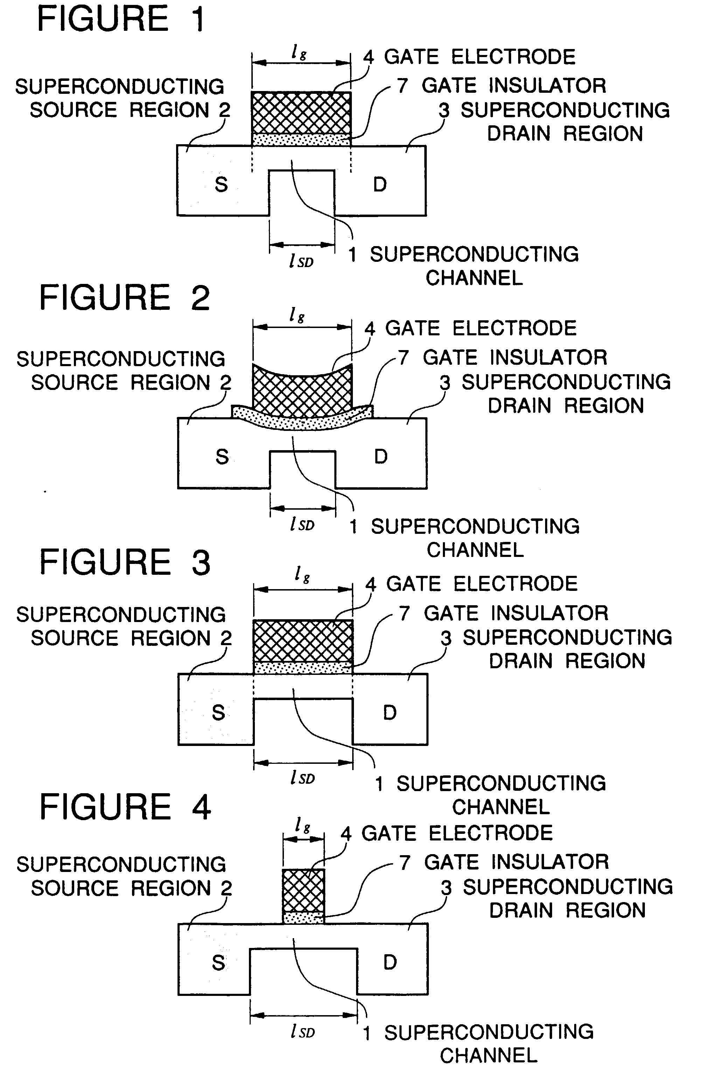

Figures 3 through 9 are diagrammatic sectional views of embodiments of the super-FETs in accordance with the present invention, whereas Figures 1 and 2 serve for illustration of the general structure of a super-FET.

### Description of the Preferred embodiments

Figure 1 shows a diagrammatic sectional view of a super-FET. The super-FET includes a superconducting source region 2 and a superconducting drain region 3 of an oxide superconductor, and a thin superconducting channel 1 of the oxide superconductor, which connects the top portions of the superconducting source region 2 and the superconducting drain region 3. The super-FET further includes a gate insulator 7 on the superconducting channel 1 and a gate electrode 4 on the gate insulator 7. The superconducting channel 1, the superconducting source region 2 and the superconducting drain region 3 of the super-FET have a planar upper surface. This planar upper surface is desirable to form a long gate electrode 4.

The length *l*_{*SD*} of the superconducting channel preferably ranges from 100 to 1000 nanometers. The length *l*_{*SD*} is determined by fine processing capability and epitaxial growth ability between the superconducting source region and the superconducting drain region. As mentioned above, the gate electrode is longer than the superconducting channel. If the gate electrode is too long, the gate electrode has a too large capacity and the overlaps between the gate electrode and the superconducting source region and between the gate electrode and the superconducting drain region generate parasitic capacities. These capacities inhibit the rapid operation. The parasitic capacities also make the characteristics poor and result in inferior performance.

On the other hand, the superconducting channel has a thickness of several nanometers, preferably less than five nanometers. This extremely thin superconducting channel is necessary for complete ON/OFF operation.

The gate insulator should have a thickness more than ten nanometers which is sufficient to prevent a tunnel current. However, if the gate insulator is too thick, the applied gate voltage is absorbed by the gate capacity and little electric field is generated in the superconducting channel. Therefore, the required voltage which controls the current of the superconducting channel becomes too high so that it is difficult to control the current of the superconducting channel by the voltage applied to the gate electrode. Therefore, the gate insulator preferably has a thickness of 10 to 100 nanometers.

The superconducting source region and the superconducting drain region have a sufficient thickness for forming contacts on them, for example several hundreds nanometers.

It is preferable that the superconducting channel, superconducting source region and superconducting drain region of the super-FET of the present invention is formed of for example Y₁Ba₂Cu₃O_{7-δ} oxide superconductor material. In this connection, these superconducting regions are preferably formed of not only Y₁Ba₂Cu₃O_{7-δ} oxide superconductor material but also a high-T_{c} (high critical temperature) oxide superconductor material, particularly a high-T_{c} copper-oxide type compound oxide superconductor material, for example a Bi-Sr-Ca-Cu-O compound oxide superconductor material, and a Tl-Ba-Ca-Cu-O compound oxide superconductor material. These oxide superconductor have a carrier density of 10²⁰ - 10²¹ /cm³.

The oxide superconductor has a large current density in the direction perpendicular to *c*-axis of its crystal. Therefore, the superconducting channel is preferably formed of a *c*-axis orientated oxide superconductor thin film, through which large superconducting current can flow in the direction parallel to its surface. In addition, the superconducting source region and the superconducting drain region are preferably formed of an *a*-axis orientated oxide superconductor thin film, through which large superconducting current can flow in the direction perpendicular to its surface.

The super-FET of the present invention is preferably manufactured on an insulating substrate, preferably an oxide single crystalline substrate such as MgO, SrTiO₃, CdNdAlO₄, YSZ, etc. These substrate materials are very effective in forming or growing a crystalline film having a high degree of crystalline orientation. However, the super-FET can be formed on a semiconductor substrate if an appropriate buffer layer is deposited thereon. For example, the buffer layer on the semiconductor substrate can be formed of a double-layer coating formed of a MgAl₂O₄ layer and a BaTiO₃ layer if silicon is used as a substrate.

Figure 2 shows a diagrammatic sectional view of a super-FET having almost the same structure as that of the super-FET of Figure 1. The difference between the super-FETs that the upper surface of the superconducting channel 1 of the super-FET shown in Figure 2 is arranged at a lower position than those of the superconducting source region 2 and the superconducting drain region 3 so that the superconducting channel 1 connects the middle portions of the superconducting source region 2 and the superconducting drain region 3. And therefore, the gate electrode 4 and the gate insulator 7 are bent along the upper surface of the superconducting channel 1, the superconducting source region 2 and the superconducting drain region 3.

In this type of the super-FET, superconducting current flows into or flows from the superconducting channel efficiently so that the current capability of the super-FET can be improved.

### Embodiment 1

Figure 3 shows a diagrammatic sectional view of a first embodiment of the super-FET in accordance with the present invention. This super-FET has a similar structure to that of the super-FET shown in Figure 1. The superconducting channel 1, the superconducting source region 2 and the superconducting drain region 3 of this super-FET has a planar upper surface as the super-FET shown in Figure 1.

The gate electrode has almost the same length of *l*_{*g*} as the length *l*_{*SD*} of the superconducting channel. The resistance of the superconducting channel is changed along its whole length, when a voltage is applied to the gate electrode. By this, large modulation of both current and voltage of the superconducting channel and complete ON/OFF operation of the superconducting channel are realized as the super-FET shown in Figure 1.

Of course, the superconducting channel 1 can be arranged at a lower position, as the super-FET shown in Figure 2, in this case. Namely, the super-FET may have a superconducting channel of which the upper surface is lower than those of the superconducting source region and the superconducting drain region so that it connects the middle portions of the superconducting source region 2 and the superconducting drain region 3, and the gate electrode 4, which has almost same length as that of the superconducting channel, and the gate insulator 7 are bent along the upper surface of the superconducting channel, the superconducting source region and the superconducting drain region.

In this type of the super-FET, superconducting current flows into or flows from the superconducting channel efficiently so that the current capability of the super-FET can be improved.

### Embodiment 2

Figure 4 shows a diagrammatic sectional view of another embodiment of the super-FET in accordance with the present invention. This super-FET also has a similar structure to that of the super-FET shown in Figure 1. The superconducting channel 1, the superconducting source region 2 and the superconducting drain region 3 of this super-FET has a planar upper surface as the super-FET shown in Figure 1.

The gate electrode has a length of *l*_{*g*} which is one third to one second of the length *l*_{*SD*} of the superconducting channel. In this type of the super-FET, unlike the super-FETs shown in Figures 1 to 3, only the resistance of the gate portion (the portion just under the gate electrode) of the superconducting channel is changed, when a voltage is applied to the gate electrode. However, this change of resistance of the gate portion is very large compared to the whole resistance of the superconducting channel. Therefore, large modulation of both current and voltage of the superconducting channel and complete ON/OFF operation of the superconducting channel are realized as the super-FET shown in Figure 1.

Of course, the superconducting channel 1 can be arranged at a lower position, as the super-FET shown in Figure 2 in this case. Namely, the super-FET may have a superconducting channel of which the upper surface is lower than those of the superconducting source region and the superconducting drain region so that it connects the middle portions of the superconducting source region 2 and the superconducting drain region 3, and the gate electrode 4, which is shorter than superconducting channel, and the gate insulator 7 are bent along the upper surface of the superconducting channel, the superconducting source region and the superconducting drain region.

In this type of the super-FET, superconducting current flows into or flows from the superconducting channel efficiently so that the current capability of the super-FET can be improved.

### Embodiment 3

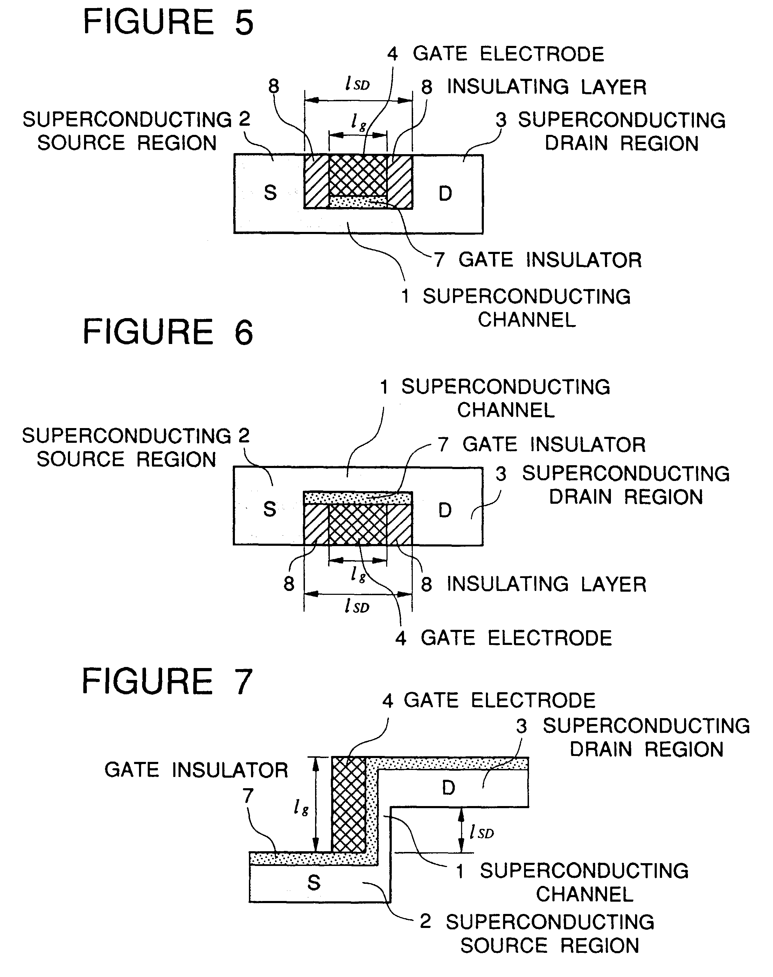

Figure 5 shows a diagrammatic sectional view of still another embodiment of the super-FET in accordance with the present invention. The super-FET includes a superconducting source region 2 and a superconducting drain region 3 of an oxide superconductor, and a thin superconducting channel 1 of the oxide superconductor, which connects the bottom portions of the superconducting source region 2 and the superconducting drain region 3. The super-FET further includes a gate insulator 7 on the superconducting channel 1, a gate electrode 4 on the gate insulator 7 between the superconducting source region 2 and the superconducting drain region 3 and an insulating layer 8 which surrounds side surfaces of the gate electrode 4 and which isolates the gate electrode 4 from the superconducting source region 2 and the superconducting drain region 3.

The super-FET has a substantially planar upper surface. This planar upper surface is favorable for forming conductor wirings in a later process.

The gate electrode has a length of *l*_{*g*} which is longer than one half of the length *l*_{*SD*} of the superconducting channel. In this type of the super-FET, unlike the super-FETs shown in Figures 1 to 3, when a voltage is applied to the gate electrode, only the resistance of the gate portion (the portion just under the gate electrode) of the superconducting channel is changed. However, the change of resistance of the gate portion is very large compared to the whole resistance of the superconducting channel. Therefore, large modulation of both current and voltage of the superconducting channel and complete ON/OFF operation of the superconducting channel are realized as the super-FET shown in Figure 1.

Other structure of the super-FET is almost the same as that of the super-FET as shown in Figure 1.

### Embodiment 4

Figure 6 shows a diagrammatic sectional view of still another embodiment of the super-FET in accordance with the present invention. The super-FET includes a superconducting source region 2 and a superconducting drain region 3 of an oxide superconductor, and a thin superconducting channel 1 of the oxide superconductor, which connects the top portions of the superconducting source region 2 and the superconducting drain region 3. The super-FET further includes a gate insulator 7 under the superconducting channel 1, a gate electrode 4 under the gate insulator 7 between the superconducting source region 2 and the superconducting drain region 3, and an insulating layer 8 which surrounds side surfaces of the gate electrode 4 and which isolates the gate electrode 4 from the superconducting source region 2 and the superconducting drain region 3. The gate insulator 7 contacts with the superconducting channel 1 from the underside and the gate electrode 4 also contacts with the gate insulator 7 from the underside.

The super-FET has a substantially planar upper surface. This planar upper surface is favorable for forming conductor wirings in a later process.

The gate electrode has a length of *l*_{*g*} which is longer than one half of the length *l*_{*SD*} of the superconducting channel. In this type of the super-FET, unlike the super-FETs shown in Figures 1 to 3, when a voltage is applied to the gate electrode, only the resistance of the gate portion (the portion just under the gate electrode) of the superconducting channel is changed. However, the change of resistance of the gate portion is very large compared to the whole resistance of the superconducting channel. Therefore, large modulation of both current and voltage of the superconducting channel and complete ON/OFF operation of the superconducting channel are realized as the super-FET shown in Figure 1.

Other structure of the super-FET is almost the same as that of the super-FET as shown in Figure 1.

### Embodiment 5

Figure 7 shows a diagrammatic sectional view of still another embodiment of the super-FET in accordance with the present invention. The super-FET includes a superconducting source region 2 and a superconducting drain region 3 of an oxide superconductor, which are placed in staggered fashion, and a thin superconducting channel 1 of the oxide superconductor which connects the superconducting source region 2 and the superconducting drain region 3. The superconducting source region 2, the superconducting channel 1 and the superconducting drain region 3 are arranged to form a crank in the named order. The super-FET further includes a gate insulator 7 which is successively formed on the upper surface of the superconducting source region 2, on the side surface of the superconducting channel 1 and on the upper surface of the superconducting drain region 3, and a gate electrode 4 which is formed on a portion of the gate insulator 7 along the superconducting channel 1.

The super-FET of this type has a smaller occupied area than super-FETs of other types. Additionally, the super-FET is easily associated with a multi-layer current path. Therefore, the super-FET is favorable for increasing integration.

In the super-FET, the length of the superconducting channel 1 is determined by thichknesses of the thin films which constitutes the superconducting source region 2 and the superconducting drain region 3. Therefore, the super-FET which has an extremely short superconducting channel is easily manufactured with good repeatability by employing the above structure.

The superconducting channel 1, the superconducting source region 2 and the superconducting drain region 3 of the super-FET are preferably constituted of oxide superconductor thin films which have the largest critical current densities in the direction in which the superconducting current flows. In this connection, if the superconducting channel 1, the superconducting source region 2 and the superconducting drain region 3 are constituted of *c*-axis orientated oxide superconductor thin films, they have the largest critical current densities in the direction in which the superconducting current flows. In addition, no grain boundary is generated between the superconducting channel 1 and the superconducting source region 2 and between the superconducting channel 1 and the superconducting drain region 3. Therefore, the super-FET of this embodiment has a high performance.

The gate electrode has a length of *l*_{*g*} which is longer than the length *l*_{*SD*} of the superconducting channel. In this type of the super-FET the resistance of the superconducting channel is changed along its whole length, when a voltage is applied to the gate electrode. By this, large modulation of both current and voltage of the superconducting channel and complete ON/OFF operation of the superconducting channel are realized.

Other structure of the super-FET is almost the same as that of the super-FET as shown in Figure 1.

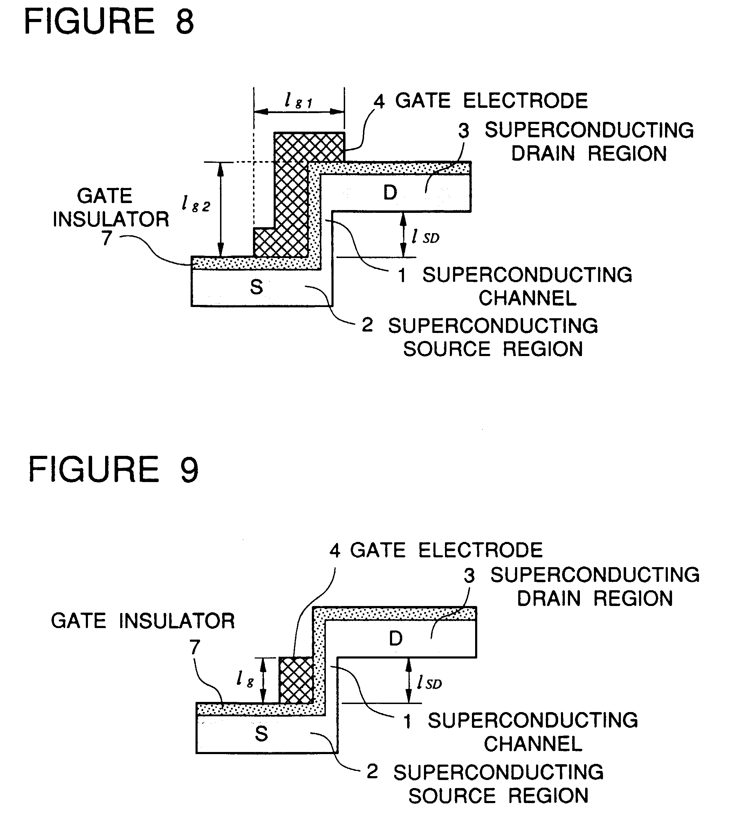

Figures 8 and 9 show variations of the super-FET of this embodiment. The super-FET shown in Figure 8 has a crank-shaped gate electrode 4 of which length is the sum of *l*_{*g1*} and *l*_{*g2*} and which is longer than the superconducting channel and not longer than one and a half length of the superconducting channel. This longer gate electrode is further favorable for the large modulation of large modulation of both current and voltage of the superconducting channel and complete ON/OFF operation of the superconducting channel.

The super-FET shown in Figure 9 has a short gate electrode 4 of which length is *l*_{*g*} which is not shorter one third length of the superconducting channel. This shorter gate electrode is favorable for rapid operation of the super-FET.

The invention has thus been shown and described with reference to the specific embodiments. However, it should be noted that the present invention is in no way limited to the details of the illustrated structures but converts and modifications may be made within the scope of the appended claims.

## Claims

1. A superconducting device comprising a thin superconducting channel (1), a superconducting source region (2) and a superconducting drain region (3) of an oxide superconductor, the superconducting source region (2) and the superconducting drain region (3) being formed at respective ends of the superconducting channel (1) which connects the superconducting source region (2) and the superconducting drain region (3), so that superconducting current can flow through the superconducting channel (1) between the superconducting source region (2) and the superconducting drain region (3), and a gate electrode (4) applying an electric field to the superconducting channel through a gate insulator (7) for controlling the superconducting current flowing through the superconducting channel (1), characterized in that the superconducting channel (1) connects the top portions of the superconducting source region and the superconducting drain region and has a length which is the shortest distance between the superconducting source region and the superconducting drain region, the gate insulator (7) is disposed on the bottom side of the superconducting channel (1), and the gate electrode (4) is disposed on the bottom side of the gate insulator (7), and in that the gate electrode (4) is equal to or longer than one third of the length of the superconducting channel (1) but shorter than the superconducting channel (1).

2. A superconducting device as claimed in Claim 1, characterized in that upper surfaces of the superconducting channel (1) has a length (l_{SD}) of 100 to 1000 nanometers.

3. A superconducting device as claimed in Claim 2, characterized in that the gate electrode (4) has a length (l_{g}) of at least 75 nanometers.

4. A superconducting device as claimed in anyone of Claims 1 to 3, characterized in that upper surfaces of the superconducting channel (1), the superconducting source region (2) and the superconducting drain region (3) of the superconducting device form an almost planar plane.

5. A superconducting device as claimed in anyone of Claims 1 to 4, characterized in that the superconducting channel (1) has a thickness of several nanometers.

6. A superconducting device as claimed in Claim 5, characterized in that the superconducting channel (1) has a thickness of less than five nanometers.

7. A superconducting device comprising a thin superconducting channel (1), a superconducting source region (2) and a superconducting drain region (3) of an oxide superconductor, the superconducting source region and the superconducting drain region (3) being formed at respective ends of the superconducting channel (1) which connects the superconducting source region (2) and the superconducting drain region (3), so that superconducting current can flow through the superconducting channel (1) between the superconducting source region (2) and the superconducting drain region (3), and a gate electrode (4) applying an electric field to the superconducting channel through a gate insulator (7) for controlling the superconducting current flowing through the superconducting channel (1), characterized in that the superconducting source region (2) and the superconducting drain region (3) are placed in stagged fashion and the superconducting source region (2), the superconducting channel (1) and the superconducting drain region (3) are arranged to form a crank in the named order, and in that the superconducting channel (1) has a length l_{SD} which is the shortest distance between the superconducting source region (2) and the superconducting drain region (3), and the length of the gate electrode (4) ranges from one third of the length of the superconducting channel (1) to one and a half times the superconducting channel length.

8. A superconducting device as claimed in anyone of Claims 1 to 7, characterized in that the oxide superconductor is formed of high-T_{c} (high critical temperature) oxide superconductor.

9. A superconducting device as claimed in Claim 8, characterized in that the oxide superconductor is formed of a high-T_{c} copper-oxide type compound oxide superconductor.

10. A superconducting device as claimed in Claim 9, characterized in that the oxide superconductor is formed of oxide superconductor material selected from the group consisting of a Y-Ba-Cu-O compound oxide superconductor material, a Bi-Sr-Ca-Cu-O compound oxide superconductor material, and a Tl-Ba-Ca-Cu-O compound oxide superconductor material.

11. A superconducting device as claimed in anyone of Claims 1 to 10, characterized in that the superconducting device is disposed on a substrate formed of a material selected from the group consisting of a MgO (100) substrate, a SrTiO₃ (100) substrate and a CdNdAlO₄ (100) substrate, and a semiconductor substrate.

12. A superconducting device as claimed in Claim 11, characterized in that the substrate is formed of a silicon substrate and a principal surface of the silicon substrate is coated with an insulating material layer which is formed of a MgAl₂O₄ layer and a BaTiO₃ layer.

## Patentansprüche

1. Supraleitendes Bauelement, aufweisend einen dünnen supraleitenden Kanal (1), einen supraleitenden Source-Bereich (2) und einen supraleitenden Drain-Bereich (3) aus einem oxidischen Supraleiter, wobei der supraleitende Source-Bereich (2) und der supraleitende Drain-Bereich (3) an jeweiligen Enden des supraleitenden Kanals (1) gebildet sind, der den supraleitenden Source-Bereich (2) mit dem supraleitenden Drain-Bereich (3) verbindet, so daß der Supraleitungsstrom durch den supraleitenden Kanal (1) zwischen dem supraleitenden Source-Bereich (2) und dem supraleitenden Drain-Bereich (3) fließen kann, und eine Gate-Elektrode (4) zum Anlegen eines elektrischen Felds an den supraleitenden Kanal durch einen Gate-Isolator (7) zum Steuern des Supraleitungsstrom, der durch den supraleitenden Kanal (1) fließt, dadurch gekennzeichnet, daß der supraleitende Kanal (1) die oberen Abschnitte des supraleitenden Source-Bereichs und des supraleitenden Drain-Bereichs verbindet und eine Länge aufweist, die den kürzesten Abstand zwischen dem supraleitenden Source-Bereich und dem supraleitenden Drain-Bereich entspricht, wobei der Gate-Isolator (7) auf der Unterseite des supraleitenden Kanals (1) angeordnet ist, und wobei die Gate-Elektrode (4) auf der Unterseite des Gate-Isolators (7) angeordnet ist, und daß die Gate-Elektrode (4) gleich oder länger als ein Drittel der Länge des supraleitenden Kanals (1), jedoch kürzer als der supraleitende Kanal (1) ist.

2. Supraleitendes Bauelement nach Anspruch 1, dadurch gekennzeichnet, daß die Oberseite des supraleitenden Kanals eine Länge (l_{SD}) von 100 bis 1000 Nanometern aufweist.

3. Supraleitendes Bauelement nach Anspruch 2, dadurch gekennzeichnet, daß die Gate-Elektrode (4) eine Länge (l_{g}) von wenigstens 75 Nanometern aufweist.

4. Supraleitendes Bauelement nach einem der Ansprüche 1 bis 3, dadurch gekennzeichnet, daß die Oberseiten des supraleitenden Kanals (1), des supraleitenden Source-Bereichs (2) und des supraleitenden Drain-Bereichs (3) des supraleitenden Bauelements eine nahezu ebene Ebene bilden.

5. Supraleitendes Bauelement nach einem der Ansprüche 1 bis 4, dadurch gekennzeichnet, daß der supraleitende Kanal (1) eine Dicke von mehreren Nanometern aufweist.

6. Supraleitendes Bauelement nach Anspruch 5, dadurch gekennzeichnet, daß der supraleitende Kanal (1) eine Dicke von weniger als 5 Nanometern aufweist.

7. Supraleitendes Bauelement, aufweisend einen dünnen supraleitenden Kanal (1), einen supraleitenden Source-Bereich (2) und einen supraleitenden Drain-Bereich (3) aus einem oxidischen Supraleiter, wobei der supraleitende Source-Bereich (2) und der supraleitende Drain-Bereich (3) an jeweiligen Enden des supraleitenden Kanals (1) gebildet sind, der den supraleitenden Source-Bereich (2) mit dem supraleitenden Drain-Bereich (3) verbindet, so daß der Supraleitungsstrom durch den supraleitenden Kanal (1) zwischen dem supraleitenden Source-Bereich (2) und dem supraleitenden Drain-Bereich (3) fließen kann, und eine Gate-Elektrode (4) zum Anlegen eines elektrischen Felds an den supraleitenden Kanal durch einen Gate-Isolator (7) zum Steuern des Supraleitungsstrom, der durch den supraleitenden Kanal (1) fließt, dadurch gekennzeichnet, daß der supraleitende Source-Bereich (2) und der supraleitende Drain-Bereich (3) übereinander angeordnet sind, und der supraleitende Source-Bereich (2), der supraleitende Kanal (1) und der supraleitende Drain-Bereich (3) angeordnet sind, eine Kurbelform in der genannten Abfolge zu bilden, und daß der supraleitende Kanal (1) eine Länge (l_{SD}) aufweist, die den kürzesten Abstand zwischen dem supraleitenden Source-Bereich (2) und dem supraleitenden Drain-Bereich (3) entspricht, und die Länge der Gate-Elektrode (4) von einem Drittel der Länge des supraleitenden Kanals (1) bis zu dem Anderthalbfachen der Länge des supraleitenden Kanals beträgt.

8. Supraleitendes Bauelement nach einem der Ansprüche 1 bis 7, dadurch gekennzeichnet, daß der oxidische Supraleiter aus einem oxidischen Supraleiter mit hoher T_{c} (hohe kritische Temperatur) gebildet ist.

9. Supraleitendes Bauelement nach Anspruch 8, dadurch gekennzeichnet, daß der oxidische Supraleiter aus einem supraleitenden Verbundoxid vom Kupferoxid-Typ mit hoher T_{c} gebildet ist.

10. Supraleitendes Bauelement nach Anspruch 9, dadurch gekennzeichnet, daß der oxidische Supraleiter aus einem oxidischen supraleitenden Material gebildet ist, das aus der Gruppe ausgewählt ist, die aus einem supraleitenden Y-Ba-Cu-O-Verbundoxid, einem supraleitenden Bi-Sr-Ca-Cu-O-Verbundoxid und einem supraleitenden Tl-Ba-Ca-Cu-O-Verbundoxid besteht.

11. Supraleitendes Bauelement nach einem der Ansprüche 1 bis 10, dadurch gekennzeichnet, daß das supraleitende Bauelement auf einem Substrat angeordnet ist, das aus einem Material gebildet ist, das aus der Gruppe ausgewählt ist, die aus einem MgO(100)-Substrat, einem SrTiO₃(100)-Substrat und einem CdNdAlO₄(100)-Substrat und einem Halbleiter-Substrat besteht.

12. Supraleitendes Bauelement nach Anspruch 11, dadurch gekennzeichnet, daß das Substrat aus einem Siliciumsubstrat gebildet ist, und eine Hauptoberfläche des Siliciumsubstrats mit einer Schicht aus isolierendem Material beschichtet ist, die aus einer MgAl₂O₄-Schicht und einer BaTiO₃-Schicht gebildet ist.

## Revendications

1. Dispositif supraconducteur comprenant un canal mince supraconducteur (1), une zone de source supraconductrice (2) et une zone de drain supraconductrice (3) constitués d'un oxyde supraconducteur, la zone de source supraconductrice (2) et la zone de drain supraconductrice (3) étant formées aux extrémités respectives du canal supraconducteur (1) , lequel connecte la zone de source supraconductrice (2) et la zone de drain supraconductrice (3), de sorte qu'un courant supraconducteur peut circuler à travers le canal supraconducteur (1) entre la zone de source supraconductrice (2) et la zone de drain supraconductrice (3) , et une électrode de grille (4) appliquant un champ électrique au canal supraconducteur à travers un isolateur de grille (7) pour commander le courant supraconducteur circulant à travers le canal supraconducteur (1), caractérisé en ce que le canal supraconducteur (1) connecte les parties supérieures de la zone de source supraconductrice et de la zone de drain supraconductrice et possède une longueur qui est la distance la plus courte entre la zone de source supraconductrice et la zone de drain supraconductrice, l'isolateur de grille (7) est disposé sur le côté inférieur du canal supraconducteur (1) et l'électrode de grille (4) est disposée sur le côté inférieur de l'isolateur de grille (7), et en ce que l'électrode de grille (4) est égale à, ou plus longue que un tiers de la longueur du canal supraconducteur (1) mais plus courte que le canal supraconducteur (1).

2. Dispositif supraconducteur selon la revendication 1 , caractérisé en ce que les surfaces supérieures du canal supraconducteur (1) possèdent une longueur (l_{SD}) de 100 à 1000 nanomètres.

3. Dispositif supraconducteur selon la revendication 2, caractérisé en ce que l'électrode de grille (4) possède une longueur (l_{g}) d'au moins 75 nanomètres.

4. Dispositif supraconducteur selon l'une quelconque des revendications 1 à 3, caractérisé en ce que les surfaces supérieures du canal supraconducteur (1), de la zone de source supraconductrice (2) et de la zone de drain supraconductrice (3) du dispositif supraconducteur forment un plan presque plat.

5. Dispositif supraconducteur selon l'une quelconque des revendications 1 à 4 , caractérisé en ce que le canal supraconducteur (1) présente une épaisseur de plusieurs nanomètres.

6. Dispositif supraconducteur selon la revendication 5 , caractérisé en ce que le canal supraconducteur (1) présente une épaisseur inférieure à cinq nanomètres.

7. Dispositif supraconducteur comprenant un canal mince supraconducteur (1), une zone de source supraconductrice (2) et une zone de drain supraconductrice (3) constitués d'un oxyde supraconducteur , la zone de source supraconductrice et la zone de drain supraconductrice (3) étant formées aux extrémités respectives du canal supraconducteur (1), lequel connecte la zone de source supraconductrice (2) et la zone de drain supraconductrice (3) , de sorte qu'un courant supraconducteur peut circuler à travers le canal supraconducteur (1) entre la zone de source supraconductrice (2) et la zone de drain supraconductrice (3) , et une électrode de grille (4) appliquant un champ électrique au canal supraconducteur à travers un isolateur de grille (7) pour commander le courant supraconducteur circulant à travers le canal supraconducteur (1), caractérisé en ce que la zone de source supraconductrice (2) et la zone de drain supraconductrice (3) sont placées de façon décalée et la zone de source supraconductrice (2) , le canal supraconducteur (1) et la zone de drain supraconductrice (3) sont disposés en forme de manivelle dans l'ordre donné, et en ce que le canal supraconducteur (1) possède une longueur l_{SD} qui est la plus courte distance entre la zone de source supraconductrice (2) et la zone de drain supraconductrice (3) , et la longueur de l'électrode de grille (4) se situe dans la gamme d'un tiers de la longueur du canal supraconducteur (1) à une fois et demie la longueur du canal supraconducteur (1).

8. Dispositif supraconducteur selon l'une quelconque des revendications 1 à 7 , caractérisé en ce que l'oxyde supraconducteur est formé d'un oxyde supraconducteur à T_{c} élevée (température critique élevée).

9. Dispositif supraconducteur selon la revendication 8 , caractérisé en ce que l'oxyde supraconducteur est formé d'un supraconducteur d'oxyde composé de type oxyde de cuivre à T_{c} élevée.

10. Dispositif supraconducteur selon la revendication 9, caractérisé en ce que l'oxyde supraconducteur est formé d'un matériau d'oxyde supraconducteur sélectionné dans le groupe constitué d'un matériau supraconducteur d'oxyde composé Y-Ba-Cu-O, d'un matériau supraconducteur d'oxyde composé Bi-Sr-Ca-Cu-O et d'un matériau supraconducteur d' oxyde composé Tl-Ba-Ca-Cu-O.

11. Dispositif supraconducteur selon l'une quelconque des revendications 1 à 10, caractérisé en ce que le dispositif supraconducteur est disposé sur un substrat formé d'un matériau sélectionné dans le groupe constitué d'un substrat de MgO(100) , d'un substrat de SrTiO₃(100) et d'un substrat de CdNdAlO₄(100), et d'un substrat semi-conducteur.

12. Dispositif supraconducteur selon la revendication 11, caractérisé en ce que le substrat est formé d'un substrat de silicium et une surface principale du substrat de silicium est recouverte d'une couche de matériau isolant qui est formée d'une couche de MgAl₂O₄ et d'une couche de BaTiO₃.
